(19) Europäisches Patentamt
European Patent Office
Office européen des brevets

(11) Numéro de publication: **0 285 916 B1**

(12) **FASCICULE DE BREVET EUROPEEN**

(45) Date de publication de fascicule du brevet: **29.04.92** (51) Int. Cl.[5]: **H03M 7/50**, G06F 7/48

(21) Numéro de dépôt: **88104732.8**

(22) Date de dépôt: **24.03.88**

(54) **Procede de codage de nombres sous forme binaire et dispositif pour sa mise en oeuvre.**

(30) Priorité: **27.03.87 FR 8704278**

(43) Date de publication de la demande:
**12.10.88 Bulletin 88/41**

(45) Mention de la délivrance du brevet:
**29.04.92 Bulletin 92/18**

(84) Etats contractants désignés:
**BE DE FR GB IT LU NL SE**

(56) Documents cités:
**US-A- 3 742 198**
**US-A- 4 617 641**

(73) Titulaire: **ALCATEL CIT**
**12 Rue de la Baume**
**F-75008 Paris(FR)**

(72) Inventeur: **Remi, Léon**
**Lochrist Coatreven**
**F-22450 La Roche Derrien(FR)**

(74) Mandataire: **Weinmiller, Jürgen et al**
**Lennéstrasse 9 Postfach 24**
**W-8133 Feldafing(DE)**

**EP 0 285 916 B1**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

La présente invention concerne le codage binaire d'un nombre avec une loi de compression pseudo-logarithmique autorisant, pour un même nombre de chiffres binaires du mot de code, une gamme de codage, c'est-à-dire un ensemble de valeurs de nombre codables, plus étendue que le binaire naturel avec, en contre partie, une précision moindre, qui n'est plus de cent pour cent, une même valeur de mot de code pouvant être attribuée à plusieurs valeurs de nombres voisins.

Les codages binaires les plus connus de ce genre sont les codages MIC dits loi A et $\mu$ définis dans l'avis G 711 du CCITT qui utilisent une loi de compression logarithmique approchée par des courbes en seize segments de droite de rapport de pente égal à deux. Leurs mots de code à huit chiffres se décomposent de gauche à droite en trois parties distinctes :

- une première partie de détermination de signe constitué d'un bit de signe,
- une deuxième partie de détermination de segment constituée de trois chiffres binaires permettant en combinaison d'identifier un segment parmi huit
- et une troisième partie de détermination de l'échelon dans le segment constituée de quatre chiffres binaires permettant la détermination de l'échelon concerné dans le segment.

Les lois A et $\mu$ suivent des lois de compression dont les segments, à l'exception des deux premiers, comportent tous seize échelons dont l'amplitude double de segment en segment. La loi A présente un premier et un deuxième segment confondus ayant trente deux échelons d'amplitude 2 ce qui lui donne une gamme de codage s'étendant de - 4 095 à + 4 095 et une erreur maximale de codage, en dehors du premier segment, de 4,7 à 6,2% du deuxième au dernier segment. La loi $\mu$ présente un premier segment de seize échelons d'amplitude 2 sauf le premier d'amplitude 1 et un deuxième segment de seize échelons d'amplitude 4 ce qui lui donne une gamme de codage s'étendant de - 8158 à + 8158 et une erreur maximale de codage, en dehors du premier segment, de 9,7 à 6,3% du second au dernier segment.

Ces codages MIC, loi A et $\mu$ , bien adaptés au codage numérique de la parole présentent des inconvénients dans d'autres applications telles que la transmission des taux d'erreurs dans les équipements répartis le long d'une liaison de transmission numérique. En effet, ces taux d'erreurs qui sont des nombres d'erreurs détectés par cycle de surveillance, occupent une gamme plus importante que la gamme de codage des codes MIC lois A et $\mu$, même modifiés en tenant compte de l'inutilité du bit de signe, et nécessitent une précision de codage non uniforme, grande en bas de gamme et juste suffisante en haut de gamme pour repérer les ordres de grandeur des fortes valeurs. Il importe en effet d'avoir une grande précision de codage pour un taux d'erreurs de faible valeur qui peut se produire alors que la liaison est en état de fonctionnement pour pouvoir repérer à partir d'un terminal surveillé les erreurs isolées, régulières ou aléatoires et assurer un suivi de la qualité de fonctionnement des équipements répartis le long de la liaison suffisamment précis pour l'établissement d'un programme de maintenance avec interventions préventives évitant les ruptures du trafic tandis que la connaissance d'un ordre de grandeur ou d'un dépassement de gamme en cas de forts taux d'erreurs facilite la recherche de l'équipement défaillant.

Il est possible d'améliorer la précision des codages MIC lois A et $\mu$ en multipliant par deux les valeurs des nombres avant de les coder. Cela introduit une première sous-gamme (0-31 pour la loi A) où la précision de codage est totale mais au prix d'une diminution de moitié de la gamme totale de codage (0-2.047 pour la loi A) déjà insuffisante pour les applications précitées.

Dans les applications précitées, il importe en outre que le codage soit facile à mettre en oeuvre à l'aide de compteurs, les erreurs détectées par cycle de surveillance qui constituent un taux d'erreur étant, à l'origine, disponibles sous forme d'impulsions de dénombrement.

La présente invention a pour but un procédé de codage de nombre sous forme binaire, avec une loi de compression pseudo-logarithmique, aux caractéristiques améliorées par rapport aux codages MIC lois A et $\mu$ , tant en ce qui concerne la précision en bas de gamme que l'étendue totale de la gamme de codage, qui soit bien adapté à la transmission des taux d'erreurs des équipements répartis le long d'une liaison de transmission numérique.

Elle a également pour but un procédé de codage de nombres sous forme binaire, avec un loi de compression pseudo-logarithmique qui puisse être mis en oeuvre à partir de nombres disponibles sous forme d'impulsions de dénombrement, à l'aide d'un dispositif de comptage simple et fiable pouvant faire partie d'un équipement peu accessible comme le sont, en général, les équipements répartis le long d'une liaison de transmission numérique.

Elle a pour objet un procédé de codage de nombres sous forme binaire avec loi de compression pseudo-logarithmique approchée par une courbe en segments de droite consistant à coder un nombre non signé sous la forme d'un mot de code à n + 1 chiffres binaires, n étant un entier invariant, comportant :

- une partie gauche constituée d'un nombre p variable de chiffres binaires de même valeur dite 1, le nombre p correspondant au numéro d'ordre du segment concerné de la loi de compression compté depuis l'origine et étant choisi égal au décalage vers la gauche, relativement à la position de chiffre de plus fort poids du mot de code, de l'élément binaire le plus significatif du nombre à coder exprimé en binaire naturel et augmenté de $2^n$
- et une partie droite constituée, lorsqu'elle existe, d'un nombre binaire ayant à la position du chiffre de plus fort poids un élément binaire de séparation de valeur dite 0 complémentaire de celle des chiffres binaires de la partie gauche et correspondant à l'expression en binaire naturel du nombre à coder augmenté de $2^n$ puis tronqué vers la droite de 2 p chiffres et privé sur la gauche de son élément binaire le plus significatif.

Ce procédé de codage permet de coder avec une précision totale une première sous-gamme de 0 à $2^n$-1 qui correspond, pour un mot à sept chiffres comparable en importance au mot de code du codage MIC loi A ou sans le bit de signe, à une sous-gamme de 0 à 63 double de celle obtenue avec un codage MIC loi A non signé appliqué à des nombres doublés de valeur avant codage. La gamme totale de codage, 0 à $2^{2n+1}$-$2^n$ correspond pour un mot de code à sept chiffres à une gamme de 0 à 8128 également nettement supérieure à celle 0 à 2047 d'un codage MIC loi A non signé appliqué à des nombres doublés de valeur avant codage.

Ce procédé de codage suit une loi de compression pseudo-logarithmique avec des segments de droite correspondant à des sous-gammes distinctes de codage dont les étendues doublent à chaque passage d'une sous-gamme inférieure à une sous-gamme supérieure et ayant des rapports de pentes successifs égaux à 1/4. Il a la particularité d'une part d'avoir des étendues de sous-gamme qui présentent chacune un nombre d'échelons égal à une puissance de deux ce qui permet à un compteur les parcourant aux pas de leurs échelons d'avoir ses chiffres de poids inférieurs naturellement remis à zéro aux franchissement d'un seuil entre deux sous-gammes et d'autre part d'avoir une partie gauche de mot de code définit de telle sorte que sa modification au passage entre deux sous-gammes peut être faite simplement en lui ajoutant le chiffre de dépassement d'un compteur parcourant les segments aux pas de leurs échelons. Cette particularité permet d'obtenir le mot de code dans son ensemble, à l'aide d'un compteur binaire attaqué par des impulsions de dénombrement définissant le nombre à coder, par l'intermédiaire d'un diviseur binaire à rapports de division multiples de quatre correspondant aux pas entre échelons des différents segments de la loi de compression, correctement synchronisé et changé de rapport de division aux franchissements des seuils entre sous-gammes.

La présente invention a également pour objet un dispositif de mise en oeuvre du procédé précité à partir d'un nombre à coder disponible sous forme d'impulsions de dénombrement, comportant :

- un circuit de division à rapports de division multiples opérant sur la suite des impulsions de dénombrement et ayant une sortie à rapport de division $2^n$, n+1 étant le nombre de chiffres du mot de code, et une autre sortie à rapport de division sélectionnable sur commande parmi les puissances de quatre correspondant aux numéros d'ordre des segments de la loi de compression comptés depuis l'orgine, le premier ayant le numéro d'ordre 0,
- un circuit de synchronisation et de sélection du rapport de division du circuit de division déterminant par comptage des paquets de $2^n$ impulsions de dénombrement détectés par le circuit de division et par repérage des franchissements, par le nombre de ces paquets, des valeurs de seuil $2^i$-1, i étant un entier compris entre 1 et n, les franchissements des seuils inférieurs de sous-gammes correspondant aux segments de la loi de compression de numéro d'ordre i, commandant au circuit de division la sélection du rapport de division correspondant à la ième puissance de quatre et resynchronisant le circuit de division après un franchissement de seuil inférieur de sous-gammes et
- un circuit de comptage à n+1 étages opérant sur la suite d'impulsions délivrée par la sortie à rapport de division sélectionnable du circuit de division et délivrant un compte donnant la valeur du mot de code correspondant à tout instant au nombre des impulsions de dénombrement appliquées au circuit de division.

D'autres avantages et caractéristiques de l'invention ressortiront de la description ci-après d'un mode de réalisation donné à titre d'exemple. Cette description sera faite en regard du dessin dans lequel :

- la figure 1 représente un circuit de comptage mettant en oeuvre le procédé de codage selon l'invention,
- la figure 2 représente un organigramme de décodage par microprocesseur de mots de code codés selon le procédé de codage selon l'invention.

Un procédé de codage binaire avec loi de compression pseudo-logarithmique a pour objet d'exprimer par un mot de code binaire une suite de nombres s'étalant dans une gamme plus étendue que ne l'autorise les différents états possibles du mot de code en attribuant à certains états du mot de code plusieurs

valeurs consécutives du nombre à coder tout en cherchant à conserver la meilleure précision possible au décodage. Une manière d'opérer consiste à exprimer le nombre à coder en binaire naturel et à le tronquer suffisamment du côté des chiffres de plus faibles poids pour le ramener à la longueur permise par le mot de code. Comme l'importance de la troncature nécessaire est variable, on est conduit à réserver une place dans le mot de code pour identifier l'amplitude de la troncature ce qui restreint d'autant la place restante pour le nombre tronqué et limite la gamme de codage par le fait que l'on ne peut repérer dans le mot de code qu'un nombre réduit d'amplitude de troncatures.

Le codage MIC loi A mis en oeuvre sans inversion des bits pairs sur des nombres non signés multipliés au préalable par deux suit cette manière d'opérer, puisque son mot de code formé de sept bits, non compris le bit de signe, se décompose en une partie gauche à trois chiffres binaires qui sert à identifier un segment parmi huit dans la partie positive ou négative de la courbe de compression et qui code en binaire naturel la position, au delà du quatrième chiffre, du premier élément binaire significatif du nombre à coder exprimé en binaire naturel, et en une partie droite à quatre chiffres binaires qui sert à identifier l'échelon dans le segment concerné et qui est constituée des quatre bits de plus forts poids après le premier élément binaire significatif ou à défaut, des quatre bits de plus faibles poids, du nombre à coder exprimer en binaire naturel.

Ainsi, le nombre 1025 qui s'exprime en binaire naturel par 100 0000 0001 a son premier élément binaire significatif en septième position au delà du quatrième chiffre ce qui donne une partie gauche du mot de code : 111 et 0000 comme quatre bits de plus fort poids après l'élément binaire le plus significatif ce qui conduit au mot de code 111 0000.

Le nombre 15 qui s'exprime en binaire naturel par 1111 a son premier élément binaire significatif qui n'est pas au delà du quatrième chiffre ce qui donne une partie gauche du mode de code 000, et n'a pas quatre bits après l'élément binaire le plus significatif de sorte que ses quatre bits sont repris dans le mot de code qui est 000 1111.

Cette technique déduite de la loi A permet une troncature d'au plus sept chiffres ce qui limite la gamme de codage aux nombres dont les valeurs s'expriment en binaire naturel sur douze chiffres au maximum, sept de troncature plus les quatre repris dans le mot de code et l'élément binaire le plus significatif ce qui donne une gamme de codage de 0 à 2047. La sous-gamme ie 0 à 31 est codée sans troncature avec une précision totale et les autres sous-gammes avec des troncatures augmentant d'un chiffre en passant de l'une à l'autre.

Pour augmenter l'étendue de la première sous-gamme codée avec une précision totale il faut augmenter dans le mot de code la place réservée à l'expression du nombre tronqué ce qui ne peut se faire qu'au détriment de la place réservée à l'identification de l'amplitude de la troncature. Avec le procédé de codage déduit de la loi A qui vient d'être décrit, cela revient à restreindre de manière abusive le nombre des amplitudes possibles des troncatures et par conséquent l'étendue de la gamme de codage.

Pour résoudre ce problème, on propose de réserver dans le mot de code pour l'identification de la troncature, une place de longueur variable d'autant plus restreinte que l'amplitude de la troncature est faible, en identifiant cette dernière à la longueur d'une suite d'éléments binaires de même valeur supposée être 1 dans les exemples décrits et en assurant la reconnaissance de cette suite dans la partie gauche du mot de code au moyen d'un élément binaire de séparation qui a la valeur complémentaire supposée être 0 dans les exemples décrits et qui est toujours présent lorsque la partie droite existe.

La présence de l'élément binaire de séparation pose deux problèmes : la perte de la place qu'il occupe dans le mot de code au détriment de la partie réservée à l'expression du nombre tronqué ou non et la nécessité de sa présence systématique dans le mot de code lorsque celui-ci n'est pas constitué de la seule partie gauche.

Pour récupérer la place qu'il occupe, on admet, lorsque le nombre à coder est tronqué, que l'élément binaire de séparation représente, à une inversion près, la valeur constante de l'élément binaire le plus significatif du nombre tronqué ce qui asure du même coup sa présence lorsque la partie tronquée du nombre figure dans le mot de code, ceci lorsque le nombre à coder n'appartient pas aux plages de valeurs chacune délimitée inférieurement, en l'incluant, par une valeur multiple d'une puissance de deux moins une unité du poids binaire de la position de chiffre de plus fort poids du mot de code et bornée supérieurement, sans l'inclure, par la valeur multiple de cette puissance de deux de ce poids binaire.

Pour que l'on puisse étendre cette convention aux nombres appartenant à ces plages ainsi qu'aux nombres non tronqués pour lesquels l'élément binaire de séparation est l'élément binaire le plus à gauche dans le mot de code, on ajoute systématiquement à tout nombre à coder le poids binaire de la position du chiffre de plus fort poids du mot de code et on procède à l'opération inverse au décodage.

Avec la convention précédente, le nombre à tronquer pour déterminer la partie droite du mot de code est le nombre à coder augmenté de la valeur du poids binaire de la position de chiffre la plus élevée du mot de code. La troncature s'impose dès que la position du chiffre le plus significatif de ce nombre dépasse la capacité du mot de code et doit être renouvelée avec un amplitude accrue chaque fois que cette position du chiffre le plus significatif se décale vers la gauche. Elle doit se faire par pas minimum de deux chiffres l'un des chiffres permettant de supprimer le dépassement dû à un décalage vers la gauche du chiffre binaire le plus significatif et l'autre chiffre permettant de tenir compte de la réduction d'un chiffre de la partie droite du mot de code réservée au résultat de la troncature car chaque augmentation d'amplitude de la troncature est repérée par une augmentation d'un chiffre de la suite constituant la partie gauche du mot de code.

Le mot de code finalement obtenu, de longueur fixe, est composé de deux parties d'importances relatives variables en fonction de la valeur du nombre à coder : une partie gauche identifiant l'amplitude de la troncature c'est-à-dire en fait la sous-gamme de codage dans laquelle on se trouve, et une partie droite contenant le résultat de la troncature c'est-à-dire en fait la position du nombre à coder dans la sous-gamme concerné.

La partie gauche du mot de code est une suite de chiffres binaires de valeur 1 dont le nombre correspond au décalage relatif vers la gauche, par rapport à la position de chiffre de plus fort poids du mot de code, du chiffre le plus significatif du nombre binaire résultant de l'addition au nombre à coder exprimer en binaire, du poids de la position de chiffre de plus fort poids du mot de code, le nombre d'éléments de cette suite pouvant également être identifié à l'excès de poids, exprimé en puissance de 2 et relativement à la position de chiffre de plus fort poids du mot de code, du nombre binaire résultant de l'addition du nombre à coder et du poids de la position de chiffre de plus fort poids du mot de code.

La partie droite du mot de code est formée du nombre binaire qui résulte de l'addition au nombre à coder du poids de la position de chiffre de plus fort poids du mot de code, dont le chiffre le plus significatif a été complémenté c'est-à-dire transformé en 0 et qui a été tronqué à droite d'un nombre de chiffre double de celui de la partie gauche du mot de code.

La partie gauche du mot de code peut être inexistante ou aller jusqu'à occuper tout le mot de code. Lorsqu'elle est inexistante, aucune troncature n'est effectuée et le nombre à coder exprimé en binaire naturel se retrouve à l'identique dans le mot de code car les opérations d'addition du poids de la position de plus fort poids du mot de code et de complémentation du chiffre le plus significatif du résultat s'annihilent mutuellement. Lorsqu'elle occupe totalement le mot de code, la valeur maximale de la gamme de codage est atteinte.

Les différentes amplitudes de troncature identifiées par le nombre de chiffres de la partie gauche du mot de code correspondent à différentes sous-gammes de codage coïncidant avec les segments de la loi de compression logarithmique. L'étendue d'une sous-gamme de codage double à chaque passage d'une sous-gamme inférieure à une sous-gamme supérieure tandis que le pas avec lequel elle est parcourue, c'est-à-dire au bout duquel la valeur du mot de code change, quadruple car la troncature, telle qu'elle a été définie, a une amplitude constante sauf lors d'un décalage vers la gauche, au delà de la position de chiffre de plus fort poids du mot de code, du chiffre le plus significatif du nombre binaire résultant de l'addition d'une constante au nombre à coder où cette amplitude est augmentée de deux chiffres binaires. Ainsi, avec un mot de code à n + 1 chiffres, une partie gauche à p chiffres correspond à une sous-gamme de codage s'étendant de $2^n(2^p-1)$ à $2^n(2^{p+1}-1)-1$ parcourue avec un pas de $4^p$.

Le quadruplement du pas, au passage d'une sous-gamme de codage inférieure à une sous-gamme de codage supérieure correspond, pour les segments de la loi de compression pseudo-logarithmique à des rapports de pente de 1/4.

L'augmentation du pas plus rapide que celle de l'étendue des sous-gammes conduit, d'une sous-gamme inférieure à une sous-gamme supérieure, à une progression de l'erreur maximale de codage ; celle-ci s'exprime avec les notations précédentes par la relation :

$$\frac{(4^p-1) \times 100}{2^n(2^p-1)} \quad \text{avec } p \neq o \text{ et o pour } p = o \qquad (1)$$

De nulle dans la première sous-gamme (p = o), elle tend vers 100% dans la (n + 1)ième sous-gamme (p = n), la sous-gamme correspondant à p égal à n + 1 n' étant pas bornée supérieurement et ayant une valeur plancher qui sert en fait de limite à la gamme de codage.

Pour un mot de code à sept bits, comparable en importance au mot de code d'un codage MIC loi A, le procédé de codage qui vient d'être décrit présente une gamme de codage s'étendant de 0 à 8.128 avec une première sous-gamme de 0 à 63 à précision totale de codage ce qui représente des performances nettement améliorées par rapport à un codage dérivé du codage MIC loi A appliqué à des valeurs de nombres binaires non signés doublés avant codage dont la gamme de codage va de 0 à 2.047 avec une première sous-gamme de 0 à 31 à précision totale.

La mise en oeuvre du procédé de codage, c'est-à-dire la détermination du mot de code à partir du nombre à coder relève d'une succession d'opérations élémentaires sur nombres binaires découlant de la définition même du mot de code exécutables par microprocesseur mais peut également être faite, comme on le verra ultérieurement à l'aide de compteurs.

En effet, pour déterminer la valeur d'un mot de code à n + 1 chiffres correspondant à un nombre binaire x entrant dans la gamme de codage il faut, si l'on suit la définition du mot de code :

- adopter un mot de code nul,
- additionner la valeur $2^n$ exprimé en binaire au nombre à coder x,
- rechercher par des tests de bit la position de l'élément binaire le plus significatif de la somme obtenue,
- identifier le décalage relatif de cette position par rapport à la position de chiffre de plus fort poids du mot de code,
- mettre à un dans le mot de code, en commençant par la position de chiffre de plus fort poids, un nombre de bits successifs correspondant à la valeur du décalage relatif trouvé ce qui constitue l'écriture de la partie gauche du mot de code,
- reprendre la somme obtenue, mettre à zéro son chiffre binaire le plus significatif et la décaler vers la droite d'un nombre de chiffres double de la valeur du décalage relatif précédent, le nombre résultant constituant la partie droite du mot de code et
- additionner le nombre résultant au mot de code ce qui lui donne sa valeur définitive.

La mise en oeuvre du procédé de décodage, c'est-à-dire la détermination du nombre correspondant à une valeur particulière du mot de code relève également d'une succession d'opérations élémentaires sur nombres binaires découlant de la définition même du mot de code et exécutables par microprocesseur.

En effet, pour déterminer la valeur d'un nombre binaire x à partir d'un mot de code à n + 1 chiffres il faut, si l'on suit la définition du mot de code :

- rechercher par des tests de bit la position de plus fort poids occupée dans le mot de code par un chiffre 0,
- identifier le décalage relatif de cette position par rapport à la position de chiffre de plus fort poids du mot de code,
- mettre à un cette position de plus fort poids occupée par un chiffre 0 et à zéro toutes celles situées à sa gauche,
- décaler vers la gauche le nombre obtenu du double de la valeur du décalage relatif précédent et
- retrancher la valeur $2^n$ au nombre obtenu.

Pour une meilleure compréhension du procédé de codage on va reprendre, avec un mot de code à sept bits, les exemples des valeurs 1025 et 15 déjà utilisées dans le cadre du codage dérivé du codage MIC loi A.

Le nombre 1025 s'exprime en binaire naturel par 100 0000 0001. Pour le coder, on commence par lui ajouter $2^{7-1}$ c'est-à-dire 100 0000. Il devient 100 0100 0001. Son chiffre binaire le plus significatif étant en quatrième position à gauche au delà du septième chiffre qui est la position de plus fort poids du mot de code, la partie gauche du mot de code sera 1111 et la troncature de huit chiffres de sorte que la somme se restreint à 100. La partie droite du mot de code se déduit de cette troncature en inversant le chiffre binaire le plus significatif et devient 000 ce qui conduit au mot de code 111 1000.

Le nombre 15 s'exprime en binaire naturel par 1111. Pour le coder on lui ajoute $2^{7-1}$ et il devient 100 111. Le chiffre le plus significatif de cette somme ayant la position du chiffre de plus fort poids du mot de code, cette somme n'est pas tronquée. La partie gauche du mot de code n'existe pas et la partie droite se déduit de la somme obtenue en inversant le chiffre binaire le plus significatif ce qui conduit au mot de code 000 1111 reprenant l'expression binaire du nombre à coder de départ.

Inversement pour décoder le mot de code 111 1000 obtenu précédemment, il faut repérer l'élément binaire de séparation qui est le premier zéro à partir de la gauche pour distinguer les parties gauche 1111 et droite 000 du mot de code. La complémentation de l'élément binaire de séparation dans la partie droite du mot de code donne le nombre 100 qui doit être complété par la droite de huit chiffres tronqués puisque la partie gauche est de quatre chiffres et donne le nombre : 100 0000 0000 auquel on retranche la valeur $2^{7-1}$ c'est-à-dire 100 0000 ce qui donne 11 1100 0000 correspondant en binaire naturel à la valeur 960.

Cette valeur de nombre décodée est différente de la valeur initiale de 1025 utilisée au codage car l'on se situe dans une sous-gamme où le codage ne se fait pas avec une précision de cent pour cent mais avec une erreur maximale qui est, selon la formule 1 de :

$$\frac{(4^4 - 1) \times 100}{2^{7-1} \quad (2^4 - 1)} = 26,5 \%$$

Le décodage du mot de code 000 1111 obtenu dans le deuxième exemple de codage s'effectue de la même manière. La position binaire de plus fort poids étant à 0 c'est celle de l'élément binaire de séparation. La partie gauche du mot de code est inexistante traduisant le fait qu'il n'y a pas eu de troncature. La partie droite du mot de code devient, après complémentation de l'élément binaire de séparation 100 1111. Elle n'est complétée par la droite d'aucun chiffre puisqu'il n'y a pas eu de troncature et seule la valeur $2^{7-1}$ ou 100 0000 lui est retranchée ce qui donne le nombre 000 1111 correspondant en binaire naturel à la valeur qui est celle utilisée initialement au codage car l'on se trouve dans la première sous-gamme où la précision de codage est de cent pour cent.

La définition précédemment adoptée pour le mot de code peut se mettre en équations.

Soient $n+1$ le nombre de chiffres du mot de code, chiffres auquelles on attribue de droite à gauche les poids $2^o$ à $2^n$, x(p) un nombre binaire à coder qui, ajouté à $2^n$, a un chiffre le plus significatif de poids $2^{n+p}$, M (x(p)) le mot de code correspondant avec sa partie gauche y(p) et sa partie droite z(x(p)). La troncature effectuée sur le nombre $[x(p)+2^n]$ sera de 2p chiffres à droite ce qui correspond à une partie gauche du mot de code ayant p éléments à la valeur 1 s'exprimant par :

$y(p) = 2^{n-p+1} (2^p - 1)$ (2)

et à une partie droite s'exprimant en fonction du nombre à coder x(p) en remarquant, qu'additionnée à $2^{n-p}$, elle équivaut à la troncature du nombre à coder x(p) augmenté de $2^n$ :

$$\mathrm{Int}\left[\frac{x(p)+2^n}{4^p}\right] = z\left[x(p)\right] + 2^{n-p} \quad \text{avec } z\left[x(p)\right] < 2^{n-p} \qquad (3)$$

Int étant la partie entière d'où :

$$M\left[x(p)\right] = 2^{n-p+1}\left(2^p - 1\right) + \mathrm{Int}\left[\frac{x(p) + 2^n (1-2^p)}{4^p}\right]$$

Chaque valeur de p définit une sous-gamme de codage. On note xo (p) la valeur initiale de la sous-gamme et Mo (p) le mot de code lui correspondant qui présente une partie droite nulle :

$Mo(p) = 2^{n-p+1} (2^p - 1)$

$$z\left[xo(p)\right] = \mathrm{Int}\left[\frac{xo(p) + 2^n (1-2^p)}{4^p}\right] = 0$$

Le plus petit nombre pour lequel la fonction Int s'annule est zéro :

$xo(p) = 2^n (2^p - 1)$ (4)

D'où

$$M\left[x(p)\right] = Mo(p) + Int\left[\frac{x(p) - xo(p)}{4^p}\right] \qquad (5)$$

Cette dernière relation montre que, au sein d'une même sous-gamme, il est possible d'obtenir un mot de code par comptage et division par $4^p$ du nombre d'unités séparant le nombre x(p) à coder de la valeur initiale xo(p) de la sous-gamme considérée.

On remarque alors que le franchissement de la valeur maximale d'une sous-gamme p permet une mise à jour des deux parties du mot de code.

En effet, on atteint le maximum de la sous-gamme (p) avec le plus grand nombre x1(p) pour lequel la partie droite du mot de code prend la valeur $2^{n-p} - 1$

$$z\left[x1(p)\right] = 2^{n-p} - 1 = Int\left[\frac{x1(p) + 2^n\,(1-2^p)}{4^p}\right]$$

Le plus grand nombre vérifiant cette relation est celui qui laisse le plus grand reste par la division par $4^p$ d'où

$(2^{n-p} - 1)\,4^p + 4^p - 1 = x1(p) + 2^n\,(1-2^p)$
$x1(p) = 2^n\,(2^{p+1} - 1) - 1$

Une comparaison avec la relation (4) montre que le nombre suivant est le plus petit nombre xo(p+1) de la sous-gamme supérieure (p+1). Si, au lieu de passer à la sous-gamme supérieure on continue à coder le prochain chiffre x2(p) dans la sous-gamme inférieure on obtient

$x2(p) = 2^n\,(2^{p+1} - 1)$

$$z\left[x2(p)\right] = Int\left[\frac{2^n(2^{p+1} - 1) + 2^n(1-2^p)}{4^p}\right] = 2^{n-p}$$

Or, au passage de la sous-gamme (p) à la sous-gamme supérieure (p+1) la partie gauche y du mot de code doit augmenter de $2^{n-p}$ puisque :

$y(p+1) - y(p) = 2^{n-p}\,(2^{p+1} - 1) - 2^{n-p+1}\,(2^p - 1) = 2^{n-p}$

Le passage d'une sous-gamme à une autre peut donc se faire simplement en ne quadruplant le rapport de division qu'après avoir atteint le seuil inférieur de la sous-gamme supérieure.

Comme le seuil inférieur de la première sous-gamme correspond au nombre 0, il est possible d'obtenir un mot de code à l'aide d'un compteur binaire attaqué par des impulsions de comptage représentant le nombre à coder par l'intermédiaire d'un diviseur binaire aux rapports multiples correctement synchronisé et changé de rapport au début de chaque sous-gamme c'est-à-dire chaque fois que x dépasse l'une des valeurs de seuil :

$2^n\,(2^i - 1)$ avec $0 < i \leq p$

Les relations précédentes conduisent également à une autre manière de trouver le nombre correspondant à un mot de code à la condition d'admettre que ce nombre est celui x′ qui rend l'expression

$x(p) + 2^n$

divisible par $4^p$. La relation (3) peut alors être mise sous la forme

$x'(p) = 4^p z [x(p)] + 2^n (2^p - 1)$

ce qui, compte tenu de la relation (2) peut s'écrire :

$x'(p) = 4^p z [x(p)] + y(p) 2^{p-1}$

On peut donc décoder un mot de code en repérant le nombre p d'éléments de sa partie gauche y et en additionnant le nombre constitué de la partie gauche du mot de code décalé de p-1 chiffres vers la gauche avec le nombre constitué de la partie droite du mot de code décalé de 2p chiffres vers la gauche.

La figure 1 illustre un circuit de mise en oeuvre du procédé de codage opérant par comptage et permettant d'obtenir un mot de code à huit chiffres.

Sur cette figure on distingue :

- un circuit de division 10 à rapports de division multiples opérant sur des impulsions de dénombrement formant le nombre à coder disponibles en entrée 1 avec, dans chaque sous-gamme de codage, le rapport de division correct,
- un circuit de synchronisation et de sélection 20 du rapport de division du circuit de division 10 repérant les nombres d'impulsions correspondant aux seuils inférieurs des sous-gammes et choisissant le rapport de division correct, et
- un circuit de comptage 30 proprement dit délivrant le mot de code par comptage des impulsions lui parvenant du circuit de division 10.

Le mot de code ayant huit bits au total (c.-à-d. n = 7), le nombre p d'éléments de la suite de chiffres 1 constituant la partie gauche du mot de code peut varier de zéro à huit ce qui correspond à neuf sous-gammes de codage, huit en réalité car la dernière n'est pas bornée et n'est en fait qu'une indication du dépassement. Chacune de ces huit sous-gammes de codage correspond pour le nombre à coder x au domaine

$2^7 (2^i - 1) \leqq x < 2^7 (2^{i+1} - 1) \qquad \text{avec } 0 \leqq i \leqq 7$

et nécessite un rapport de division $4^i$, la neuvième sous-gamme étant atteinte pour

$x \geqq 2^7 (2^{7+1} - 1)$.

Le circuit de division 10 comporte un premier compteur diviseur binaire 11 connecté par certaines de ses sorties parallèles à un sélecteur 12 qui attaque le circuit de comptage 30 et qui est adressé par le circuit de synchronisation et de sélection 20.

Le premier compteur diviseur binaire 11, a une commande de remise à zéro R contrôlée par le circuit de synchronisation et de sélection 20 et progresse sur les fronts descendants des impulsions lui parvenant de l'entrée générale comptage 1 qui sont les impulsions de dénombrement du nombre à coder. Il a une sortie Q7, constituée par la sortie de poids $2^6$, avec un rapport de division égal à la puissance septième de deux, utilisée par le circuit de synchronisation et de sélection 20 pour repérer les passages du nombre instantané des impulsions de dénombrement en cours de comptage par les seuils inférieurs des sous-gammes et sept sorties Q2, Q4, Q6, Q8...Q14, constituées par les sorties de poids $2^1$, $2^3$, $2^5$, $2^7$...$2^{13}$, avec des rapports de division correspondant aux différentes puissances de quatre s'échelonnant de un à sept.

Le sélecteur 12 de type un parmi huit comporte, outre ses entrées et sa sortie de données, et ses entrées d'adressage, une entrée de commande d'inhibition Inh permettant de bloquer sa sortie de données en cas de dépassement de la gamme de codage. L'une de ses entrées de données est connectée à l'entrée de comptage du premier compteur diviseur 11, constituant une sortie à rapport de division unitaire correspondant à la puissance nulle de quatre. Ses sept autres entrées de données sont connectées aux sept sorties du premier compteur divisuer 11 ayant des rapports de division correspondant aux puissances

un à sept de quatre, l'ensemble de ces connexions étant fait de manière que le nombre binaire appliqué sur les entrées d'adressage du sélecteur 12 corresponde à la puissance de quatre du rapport de division sélectionné.

Le circuit de synchronisation et de sélection 20 comporte un deuxième compteur diviseur binaire 21 avec circuit d'initialisation à un déterminant par l'état de ses sorties la sous-gamme de codage dans laquelle se situe le nombre instantané des impulsions de dénombrement en cours de comptage, un encodeur de priorité 22 connecté aux sorties de ce deuxième compteur diviseur binaire 21 déterminant le numéro d'ordre de ladite sous-gamme et contrôlant le sélecteur 12 du circuit de division 10, et un circuit de remise à zéro du premier compteur diviseur binaire 11 tous les deux changements de sous-gamme et en début de comptage.

Le deuxième compteur diviseur binaire 21 à neuf étages successifs à sorties parallèles dont la première est inutilisée et une commande de remise à zéro reliée à une entrée 2 de remise à zéro générale. Il progresse sur les fronts descendants des impulsions appliquées à son entrée de comptage qui lui parviennent par l'intermédiaire d'une porte de type "ou exclusif" 23 soit du circuit d'initialisation à un soit de la sortie Q7 du premier compteur diviseur binaire 11 ayant pour rapport de division la puissance septième de deux. L'unique impulsion émise par le circuit d'initialisation à un en début de réception de toute suite d'impulsions de dénombrement et les impulsions engendrées par le premier compteur diviseur binaire 11 tous les paquets de $2^7$ impulsions de dénombrement lui permettent de faire correspondre chaque premier passage au niveau logique 1 d'une de ses sorties de poids $2^j$, $o < j \leqq 8$ au comptage effectif de $2^7$ $(2^j - 1)$ impulsions de dénombrement c'est-à-dire à la détection de la valeur de nombre à coder repérant la seuil inférieur de la sous-gamme de codage d'ordre j. La sortie de poids $2^\circ$ est inutilisée car correspondant à la première sous-gamme de codage mise en service en début de réception d'une suite d'impulsions de dénombrement. La sortie de poids le plus fort correspondant à la dernière sous-gamme non bornée $(j = 8)$ est utilisée pour la détection des dépassements de la gamme totale de codage et sert à inhiber la sortie de données du sélecteur 12 pour éviter une remise à zéro du circuit de comptage 30 par dépassement de capacité.

L'encodeur de priorité 22 connecté aux sorties restantes du deuxième compteur diviseur binaire 21 délivre sur ses sorties contrôlant l'adressage du sélecteur 12, un nombre binaire correspondant au poids de la position de chiffre le plus élevée des sorties du deuxième compteur diviseur binaire 21 ayant pris la valeur 1 c'est-à-dire en fait à la puissance de quatre du rapport de division de la sous-gamme en cours d'utilisation.

Le circuit de remise à zéro assure la synchronisation du premier compteur diviseur binaire 11 de manière que celui-ci entame correctement le premier échelon de chaque sous-gamme. En effet, en l'absence de resynchronisation du premier compteur diviseur binaire 11 en cours de réception de toute suite d'impulsions de dénombrement, ce compteur diviseur, réinitialisé toutefois à zéro avant la réception de chaque suite d'impulsions de dénombrement, entamerait correctement le premier échelon de chaque sous-gamme d'ordre i dont le seuil inférieur, $2^n$ $(2^i-1)$, qu'il afficherait alors au démarrage de la sous-gamme, est divisible par le rapport de division, $4^i$, de cette sous-gamme, c'est-à-dire de chaque sous-gamme dont l'ordre i est inférieur ou égal à $\frac{n}{2}$ soit ici, où n est égal à 7, dont l'ordre i est inférieur ou égal à 3, et se désynchroniserait, le cas échéant, lors du passage à la première sous-gamme dont l'ordre i est supérieur ou égal à $\frac{n}{2}$ c'est-à-dire ici dont l'ordre i est égal à 4.

Pour éviter une telle désynchronisation, il suffit de façon générale de remettre à zéro le premier compteur diviseur binaire 11 à chaque changement de sous-gamme ; dans le cas considéré où n est égal à 7, il suffit de n'effectuer une telle remise à zéro que tous les deux changements de sous-gamme en commençant par le changement de la sous-gamme d'ordre 0 à la sous-gamme d'ordre 1. En effet, le compteur diviseur binaire 11 entame alors correctement le premier échelon de la sous-gamme d'ordre 0 et des sous-gammes d'ordre impair i égal à $2u+1$, $0 \leqq u \leqq 3$ ; on peut voir aisément qu'il en fait de même pour les autres sous-gammes, c'est-à-dire pour les sous-gammes d'ordre pair $2u+2$ avec u inférieur ou égal à 2, car lorsque s'entame une telle sous-gamme d'ordre $2u+2$ il affiche alors la valeur $2^{7+2u+1}$ qui, u étant inférieur ou égal à 2, est divisible par le rapport de division $4^{2u+2}$ de cette sous-gamme.

Le changement de sous-gamme est détecté par les changements de valeurs de la sortie de plus faible poids de l'encodeur de priorité 22 et le circuit de remise à zéro agit lors des transitions positives de la sortie de plus faible poids de l'encodeur de priorité 22. Pour ce faire il comporte un circuit de différentiation à capacité série 24 et résistance parallèle 25 connecté en entrée à la sortie de plus faible poids de l'encodeur de priorité 22 et un circuit de mise en forme d'impulsions constitué d'une porte logique du type "ou exclusif" 26 qui est disposée devant l'entrée de remise à zéro du premier compteur diviseur binaire 11 avec une entrée reliée à la masse et l'autre en sortie du circuit de différentiation.

Le circuit de remise à zéro comporte également deux diodes 27 et 28 reliées par leur cathode en sortie du circuit de différentiation et constituant avec la résistance 25 de celui-ci une porte logique câblée de type "ou". L'une 27 de ses diodes connectée par son anode à la sortie du dernier étage du deuxième compteur diviseur binaire 21 assure le blocage à zéro du premier compteur diviseur binaire 11 en cas de dépassement de gamme tandis que l'autre 28 connectée par son anode à une entrée 2 de remise à zéro générale assure la réinitialisation du premier compteur diviseur binaire 11 avant la réception de chaque suite d'impulsions de dénombrement.

Le circuit d'initialisation à un, de conception classique, comporte un registre à décalage à deux étages 29 cadencé par les impulsions de dénombrement disponibles sur l'entrée générale de comptage 1, remis à zéro par les ordres reçus de l'entrée générale de remise à zéro 2 et recevant sur son entrée série de données un niveau logique 1 constant, et une porte logique de type "ou exclusif" 19 dont les entrées sont connectées aux sorties des deux étages du registre à décalage 29 et dont la sortie constitue celle du circuit d'initialisation à un.

Le circuit de comptage 30 est constitué d'un troisième compteur diviseur binaire 31 à huit étages successifs à sorties parallèles et commande de remise à zéro R connectée à l'entrée 2 de remise à zéro générale, progressant sur les fronts descendants des impulsions appliqueés sur son entrée de comptage par le circuit de division 10, et d'un banc de registres tampon 32 intercalés devant les sorties parallèles du troisième compteur diviseur binaire 31 avec leur commande d'inscription contrôlée par une entrée 3 de commande de chargement commandant son chargement après la réception de chaque suite d'impulsions de dénombrement.

Ce circuit permet de coder sur un octet une gamme de nombres comprise entre 0 et $2^{15}-2^{7}-1$ (32.639) en huit sous-gammes :

- une première sous-gamme de 0 à 127 avec un pas de 1 et une erreur de codage nulle,
- une deuxième sous-gamme de 128 à 383 avec un pas de 4 et une erreur maximale de codage de 2,3%,
- une troisième sous-gamme de 384 à 895 avec un pas de 16 et une erreur maximale de codage de 3,9%,
- une quatrième sous-gamme de 896 à 1919 avec un pas de 64 et une erreur maximale de codage de 7%,
- une cinquième sous-gamme de 1920 à 3967 avec un pas de 256 et une erreur maximale de codage de 13,3%,
- une sixième sous-gamme de 3968 à 8063 avec un pas de 1024 et une erreur maximale de codage de 25,8%,
- une septième sous-gamme de 8084 à 16255 avec un pas de 4096 et une erreur maximale de codage de 50,8%,
- une huitième sous-gamme de 16256 à 32639 avec un pas de 16384 et une erreur maximale de codage de 100,7%,

et de repérer un dépassement de cette gamme.

Dans pratiquement tous les cas des liaisons de transmission numérique existantes, à équipements répartis, un taux d'erreur de $10^{-6}$ déjà important lorsqu'une liaison est en activité se traduit par un nombre d'erreurs détectées par cycle de surveillance inférieur et souvent très inférieur à 895 ce qui confère au circuit de codage une précision d'au moins 96% lorsqu'il est utilisé pour la transmission des taux d'erreurs sur une liaison numérique en activité.

La figure 2 représente un organigramme de décodage par microprocesseur de mots de code à huit chiffres obtenus par le procédé de codage selon l'invention.

Cet organigramme met en oeuvre, pour la détermination du nombre x′(p) correspondant à un mot de code M (x(p)) à partie droite z (x)p)) et partie gauche y(p), l'une de ces parties droite et gauche pouvant ne pas exister, la formule :

$$x'(p) = 4^{p} z(x(p)) + y(p)\, 2^{p-1}$$

Dans cet organigramme, la fonction de deux variables notée représente la fonction logique ET entre bits de même rang des deux variables. La valeur du nombre x′(p) cherché est celle qu'a la variable notée N à la fin du déroulement de l'organigramme.

A titre d'exemple, le tableau ci-après indique les valeurs prises par les variables OCTET, MASQUE, CMPT, R, Y, Z et N apparaissant dans cet organigramme lors du déroulement de celui-ci pour la détermination du nombre x′(p) correspondant au mot de code 11101000 issu du codage d'un nombre x(p)

compris entre 1408 et 1471. La valeur de la variable N en fin de calcul, qui est celle recherchée, est 10110000000, c'est-à-dire 1408.

| | | |
|---|---|---|
| Etat initial | CMPT = | 00000000 |
| | Y = | 0000000000000000 |
| | Z = | 0000000000000000 |
| | N = | 0000000000000000 |
| | MASQUE = | 11111111 |
| | OCTET = | 11101000 |
| | R = | 0000000011101000 |
| Décalage à gauche de R | R = | 0000000111010000 |
| Incrémentation de CMPT | CMPT = | 00000001 |
| Décalage à droite de MASQUE | MASQUE = | 01111111 |
| Décalage à gauche de R | R = | 0000001110100000 |
| Incrémentation de CMPT | CMPT = | 00000010 |
| Décalage à droite de MASQUE | MASQUE = | 00111111 |
| Décalage à gauche de R | R = | 0000011101000000 |
| Incrémentation de CMPT | CMPT = | 00000011 |
| Décalage à droite de MASQUE | MASQUE = | 00011111 |
| Décalage à gauche de R | R = | 0000111010000000 |
| Z = (OCTET). (MASQUE) | Z = | 0000000000001000 |
| Y = (OCTET). ($\overline{\text{MASQUE}}$) | Y = | 0000000011100000 |
| Décrémentation de CMPT | CMPT = | 00000010 |
| Décalage à gauche de Y | Y = | 0000000111000000 |
| Double décalage à gauche de Z | Z = | 0000000000100000 |
| Décrémentation de CMPT | CMPT = | 00000001 |
| Décalage à gauche de Y | Y = | 0000001110000000 |
| Double décalage à gauche de Z | Z = | 0000000010000000 |
| Décrémentation de CMPT | CMPT = | 00000000 |
| Double décalage à gauche de Z | Z = | 0000001000000000 |
| N = Y+Z | N = | 0000010110000000 |

## Revendications

1. Procédé de codage de nombres sous forme binaire à loi de compression pseudo-logarithmique approchée par une courbe en segments de droite consistant à coder un nombre non signé sous la forme d'un mot de code à n+1 chiffres binaires, n'étant un entier positif invariant, comportant une partie gauche de détermination du segment concerné dans la loi de compression et une partie droite

de détermination de l'échelon dans le segment concerné caractérisé en ce que :
la partie gauche du mot de code est constituée d'un nombre p variable de chiffres binaires de même valeur dite 1, le nombre p correspondant au numéro d'ordre du segment concerné de la loi de compression compté depuis l'origine et étant choisi égal au décalage vers la gauche, relativement à la position du chiffre de plus fort poids du mot de code, de l'élément binaire le plus significatif du nombre à coder exprimé en binaire naturel et augmenté de $2^n$ et en ce que :
la partie droite du mot de code est constituée, lorsqu'elle existe, d'un nombre binaire ayant à la position du chiffre de plus fort poids un élément binaire de séparation de valeur dite 0 complémentaire de celle des chiffres binaire de la partie gauche et correspondant à l'expression en binaire naturel du nombre à coder augmenté de $2^n$ puis tronqué à droite de 2p chiffres et privé de son élément binaire le plus significatif.

**2.** Dispositif de mise en oeuvre du procédé selon la revendication 1 à partir d'un nombre à coder disponible sous la forme d'une suite d'impulsions de dénombrement, caractérisé en ce qu'il comporte :
- un circuit de division (10) à rapports de division multiples opérant sur la suite des impulsions de dénombrement, et ayant une sortie à rapport de division $2^n$ et une autre sortie à rapport de division sélectionnable sur commande parmi les puissances de quatre correspondant aux numéros d'ordre des segments de la loi de compression comptés depuis l'origine, le premier ayant le numéro d'ordre 0,
- un circuit de synchronisation et de sélection (20) du rapport de division du circuit de division (10) déterminant par comptage des paquets de $2^n$ impulsions de dénombrement détectés par le circuit de division (10) et par repérage des franchissements, par le nombre de ces paquets, des valeurs de seuil $2^i$-1, i étant un entier compris de 1 à n, les franchissements des seuils inférieurs des sous-gammes correspondant aux segments de la loi de compression de numéro d'ordre i, commandant au circuit de division la sélection du rapport de division correspondant à la i ème puissance de quatre et resynchronisant le circuit de division (10) après un franchissement de seuil inférieur de sous-gammes et
- un circuit de comptage (30) à n+1 étages opérant sur la suite d'impulsions délivrée par la sortie à rapport de division sélectionnable du circuit de division (10) et délivrant un compte donnant la valeur du mot de code correspondant au nombre des impulsions de dénombrement appliquées au circuit de division (10).

**3.** Dispositif selon la revendication 2, caractérisé en ce que le circuit de division (10) comporte un compteur diviseur (11) binaire à commande de remise à zéro contôlée par le circuit de synchronisation et de sélection (20), qui opère sur les impulsions de dénombrement et présente une sortie avec un rapport de division égal à $2^n$ et une suite de sorties parallèles avec des rapports de division distincts égaux aux puissances de quatre correspondant aux numéros d'ordre des segments de la loi de compression, et un sélecteur (12) connecté à ladite suite de sorties parallèles du premier compteur diviseur binaire (11) et contrôlé par le circuit de synchronisation et de sélection (20).

**4.** Dispositif selon la revendication 2, caractérisé en ce que le circuit de synchronisation et de sélection (20) comporte :
- un compteur diviseur binaire (21) avec circuit d'initialisation à un et commande de remise à zéro qui est initialisé à un en début de chaque série d'impulsions de dénombrement et opère sur les impulsions délivrées par la sortie à rapport de division $2^n$ du circuit de division (10), qui présente des étages successifs ayant des sorties parallèles à l'exception du premier et dont le numéro d'ordre de la sortie de plus fort poids passée au niveau logique 1 correspond au numéro d'ordre du segment parcouru de la loi de compression,
- un encodeur de priorité (22) connecté en entrées aux sorties parallèles du compteur diviseur binaire (21) délivrant sur des sorties parallèles le numéro d'ordre de la sortie de plus fort poids passée au niveau logique 1 du compteur diviseur binaire (21), numéro d'ordre qui est utilisé comme commande de sélection pour le circuit de division (10)
- et un circuit de remise à zéro du circuit de division (10) opérant à partir des transitions de la sortie de plus faible poids de l'encodeur de priorité (22).

## Claims

1. A method of coding numbers in binary form using a pseudo-logarithmic compression law approximated by a curve made up of straight line segments, the method consisting in coding an unsigned number in the form of a code word comprising n + 1 binary digits where n is an invariant positive integer, said code word comprising a lefthand part determining the corresponding segment of the compression law curve and a righthand part determining the interval within the segment concerned, characterized in that
   - the lefthand part of the code word is made up of a variable number p of binary digits of the same value (hereinafter called 1), the number p corresponding to the rank number of the compression law curve segment concerned as counted from the origin and chosen as equal to the leftward shift, relative to the position of the most significiant bit of the code word, of the most significant bit of the number to be coded, expressed in natural binary and augmented by $2^n$, and
   - the righthand part of the code word, when present, is made up of a binary number having at the position of the most significant bit a separator bit the value of which (hereinafter called 0) is the complement of that of said p binary digits of said lefthand part and corresponds to the expression in natural binary of the number to be coded augmented by $2^n$ and then truncated on the right by 2p digits and deprived of is most significant bit.

2. A device for implementing the method according to claim 1 from a number to be coded provided in the form of a series of counting pulses, characterized in that it comprises:
   - a divider circuit (10) with a plurality of division ratios operating on said series of counting pulses and having one output corresponding to a division ratio of $2^n$ and another output corresponding to a variable division ratio selected from powers of 4 corresponding to the rank numbers of the segments of the compression law as counted from the origin, the first segment having the rank number 0,
   - a synchronization and selector circuit (20) which determines, by counting packets of $2^n$ counting pulses sent by the divider circuit (10) and by registering when the number of said packets crosses a threshold $2^i$-1 where i is an integer between 1 and n, when lower thresholds of subranges corresponding to the segments of the compression law curve with rank number i are crossed, and which commands said divider circuit to select the division ratio corresponding to the $i^{th}$ power of 4 and which resynchronizes said divider circuit (10) after a subrange lower threshold has been crossed, and
   - an n + 1 stage counter circuit (30) adapted to count pulses delivered by the variable division ratio output of said divider circuit (10) and to yield a count which gives the value of the code word corresponding to the number of counting pulses applied to said divider circuit (10).

3. A device according to claim 2, characterized in that said divider circuit (10) comprises a binary counter/divider (11) which has a reset to 0 command input controlled by said synchronization and selector circuit (20), which operates on said counting pulses and which has an output with a division ratio equal to $2^n$ and a series of parallel outputs with separate division ratios equal to powers of 4 corresponding to the rank numbers of the segments of the compression law, and a selector (12) connected to said series of parallel outputs of said first binary counter/divider (11) and controlled by said synchronization and selector circuit (20).

4. A device according to claim 2, characterized in that the synchronization and selector circuit (20) comprises:
   - a binary counter/divider (21) which has an initialization to 1 circuit and a reset to 0 command input and which is initialized to 1 at the beginning of each series of counting pulses and operates on the pulses delivered by the output with division ratio $2^n$ of said divider circuit (10), which has consecutive stages having parallel outputs except for the first and for which the rank number of the highest weight output that has gone to logic 1 corresponds to the rank number of the segment concerned of the compression law,
   - a priority encoder (22) having inputs connected to the parallel outputs of said binary counter/divider (21) delivering on parallel outputs the rank number of the highest weight output that has gone to logic 1 of said binary counter/divider (21), which rank number is used as a selection command input for said divider circuit (10), and
   - a circuit for resetting to 0 said divider circuit (10) operating on the basis of transitions at the lowest weight output of said priority encoder (22).

## Patentansprüche

1. Verfahren zur Kodierung von binären Zahlen nach einer pseudo-logarithmischen Kompressionsregel, die von einer Kurve aus geradlinigen Segmenten angenähert wird, wobei das Verfahren darin besteht, eine vorzeichenlose Zahl in Form eines Kodeworts mit n+1 Binärziffern zu kodieren, wobei n eine invariable positive ganze Zahl ist und das Kodewort einen linken Bestimmungsabschnitt des in der Kompressionsregel betroffenen Segments sowie einen rechten Bestimmungsabschnitt des Intervalls im betroffenen Segment aufweist, dadurch gekennzeichnet, daß
   - der linke Abschnitt des Kodeworts aus einer variablen Anzahl p von Binärziffern des gleichen Werts 1 besteht, wobei die Anzahl p der vom Ursprung aus gezählten Ordnungsnummer des von der Regel betroffenen Segments entspricht und zugleich der Linksverschiebung des signifikantesten Binärelements der zu kodierenden Zahl, ausgedrückt in natürlicher Binärkodierung und um $2^n$ erhöht, gleicht, relativ zur Position der Ziffer mit der größten Gewichtung im Kodewort, und daß
   der rechte Abschnitt des Kodeworts, wenn er existiert, aus einer Binärzahl besteht, die in der Position der Ziffer mit der größten Gewichtung ein binäres Trennelement mit dem Wert "0" aufweist, der dem der Binärziffern des linken Abschnitts komplementär ist, und die dem in natürlicher Binärkodierung wiedergegebenen Ausdruck der zu kodierenden Zahl um $2^n$ erhöht und anschließend rechts um 2p Ziffern abgeschnitten entspricht und von ihrem signifikantesten Binärelement befreit ist.

2. Einrichtung zur Durchführung des Verfahrens nach Anspruch 1 auf Basis einer zu kodierenden Zahl, die in Form einer Zählimpulsefolge vorliegt, dadurch gekennzeichnet, daß die Einrichtung aufweist:
   - eine Teilerschaltung (10) mit einer Vielzahl von Teilungsverhältnissen, die die Zählimpulsfolge verarbeitet und einen Ausgang mit dem Teilungsverhältnis $2^n$ sowie einen anderen Ausgang mit einem Teilungsverhältnis besitzt, das gesteuert unter den Potenzen von 4 wählbar ist und den Ordnungsnummern der ab Ursprung gezählten Segmente der Kompressionsregel entspricht, wobei das erste Segment die Ordnungsnummer 0 besitzt,
   - eine Schaltung (20) zum Synchronisieren und Wählen des Teilungsverhältnisses der Teilerschaltung (10), die durch Zählen der von der Teilerschaltung (10) erfaßten Pakete der $2^n$ Zählimpulse sowie durch Registrieren der Überschreitungen der Schwellenwerte $2^i$-1 der Anzahl der Pakete, wobei i eine ganze Zahl zwischen 1 und n ist, die Überschreitungen der unteren Schwellenwerte der Unterbereiche entsprechend den Segmenten der Kompressionsregel mit der Ordnungszahl i ermittelt und die bei der Teilerschaltung die Wahl des Teilungsverhältnisses entsprechend der i-ten Potenz von 4 auslöst und die Teilerschaltung (10) nach einem Überschreiten des unteren Schwellenwerts der Unterbereiche erneut synchronisiert, und
   - eine Zählschaltung (30) mit n+1 Stufen, welche die vom Ausgang mit wählbarem Teilungsverhältnis der Teilerschaltung (10) ausgegebene Impulsfolge empfängt und einen Zählwert liefert, welche den Wert des Kodeworts entsprechend der Anzahl der an die Teilerschaltung (10) angelegten Zählimpulse angibt.

3. Einrichtung nach Anspruch 2, dadurch gekennzeichnet, daß die Teilerschaltung (10) einen binären Teilerzähler (11) mit einer durch die Synchronisier- und Wählschaltung (20) gesteuerten Nullrückstellung, wobei der Teilerzähler die Zählimpulse zählt und einen Ausgang mit einem Teilungsverhältnis von $2^n$ und eine Folge von Parallelausgängen mit unterschiedlichen, den Potenzen von 4 entsprechenden Teilungsverhältnissen entsprechend den Ordnungsnummern der Segmente der Kompressionsregel, sowie einen Wähler (12) aufweist, der an die Folge der Parallelausgänge des ersten binären Teilerzählers (11) angeschlossen ist und durch die Synchronisier- und Wählschaltung (20) gesteuert wird.

4. Einrichtung nach Anspruch 2, dadurch gekennzeichnet, daß die Synchronisier- und Wählschaltung (20) aufweist:
   - einen binären Teilerzähler (21) mit einer auf "1" einstellenden Initialisierungsschaltung und mit Nullrückstellungssteuerung, der zu Beginn jeder Zählimpulsfolge auf 1 initialisiert wird und die vom Ausgang mit Teilungsverhältnis $2^n$ der Teilerschaltung (10) gelieferten Impulse zählt, der aufeinanderfolgende Stufen mit Parallelausgängen, mit Ausnahme der ersten Stufe, besitzt, und bei dem die Ordnungsnummer des auf Logikpegel "1" gegangenen Ausgangs mit der höchsten Gewichtung der Ordnungsnummer des durchlaufenden Segments der Kompressionsregel entspricht,

- einen Prioritätskodierer (22), dessen Eingänge an die Parallelausgänge des binären Teilerzählers (21) angeschlossen sind, welcher an Parallelausgängen die Ordnungsnummer des auf Logikpegel 1 gegangenen Ausgangs des binären Teilerzählers (21) mit der höchsten Gewichtung liefert, wobei diese Ordnungsnummer als Steuersignal für die Einstellung der Teilerschaltung (10) benutzt wird,
- und eine Nullrückstellungsschaltung für die Teilerschaltung (10), die auf Basis der Übergänge des Ausgangs mit der niedrigsten Gewichtung des Prioritätskodierers (22) arbeitet.

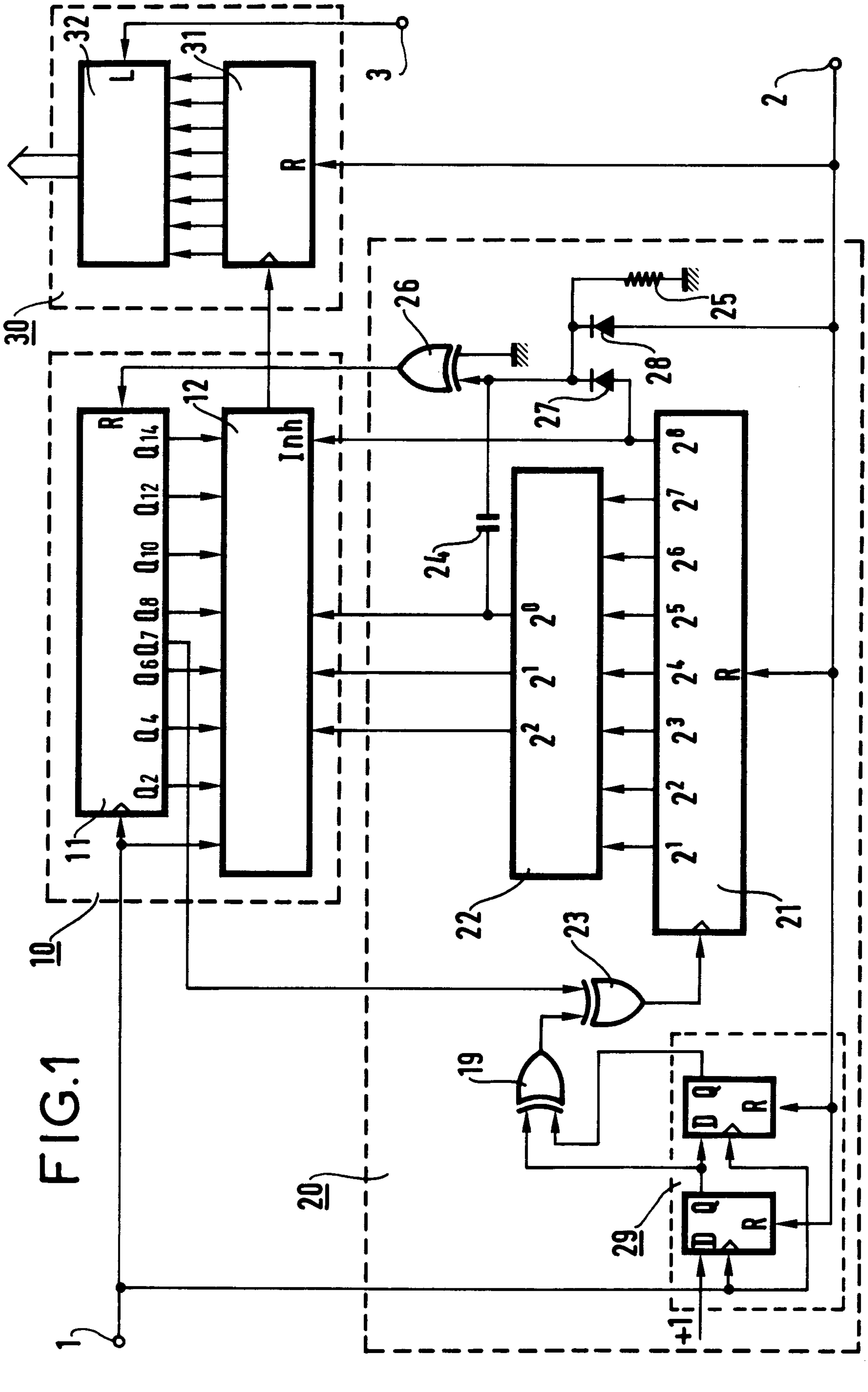
1
2
3
10
11
12
19
20
21
22
23
24
25
26
27
28
29
30
31
32
R
L
Inh
Q2
Q4
Q6
Q7
Q8
Q10
Q12
Q14
D
Q
+1

FIG.1

FIG. 2

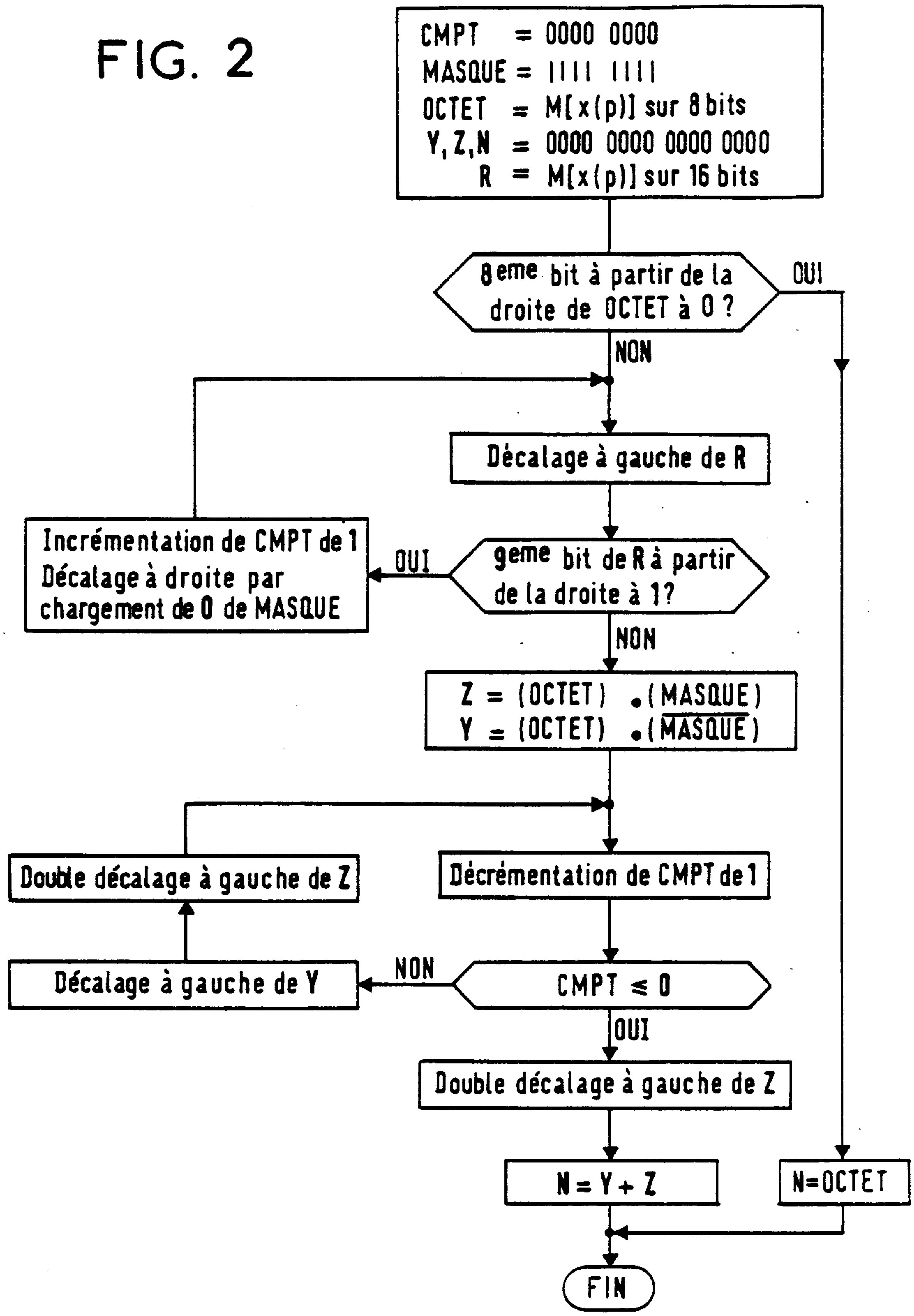
CMPT = 0000 0000
MASQUE = 1111 1111
OCTET = M[x(p)] sur 8 bits
Y, Z, N = 0000 0000 0000 0000
R = M[x(p)] sur 16 bits
8eme bit à partir de la droite de OCTET à 0 ?
OUI
NON
Décalage à gauche de R
9eme bit de R à partir de la droite à 1?
OUI
Incrémentation de CMPT de 1
Décalage à droite par chargement de 0 de MASQUE
NON
Z = (OCTET) •(MASQUE)
Y = (OCTET) •(MASQUE)
Décrémentation de CMPT de 1
Double décalage à gauche de Z
CMPT ≤ 0
NON
Décalage à gauche de Y
OUI
Double décalage à gauche de Z
N = Y + Z
N=OCTET
FIN